# EUROPEAN PATENT SPECIFICATION

(11) **EP 1 968 371 B1**
(45) Date of publication and mention of the grant of the patent: **05.12.2012**
(21) Application number: 08151141.2
(22) Date of filing: 07.02.2008
(51) Int. Cl.: H05K 9/00, G02B 5/22

(54) **Optical member and filter for display aparatus having the same**
Optisches Element und Filter für eine Anzeigevorrichtung damit
Élément optique et filtre pour appareil d'affichage en disposant

(30) Priority: 09.03.2007 KR 20070023517
(43) Date of publication of application: 10.09.2008
(73) Proprietor: Samsung Corning Precision Materials Co., Ltd., Gumi-si Gyeongsangbuk-do 730-360 (KR)
(72) Inventor: Sin, Dong Keun, 445-984 Gyeonggi-do (KR); Seo, Ji Yoon, 730-779 Gyeongsangbuk-do (KR); Jo, Sung Nim, 130-756 Seoul (KR); Oh, Sang Yoon, 730-040 Gyeongsangbuk-do (KR); Kim, Ji Young, 730-725 Gyeongsangbuk-do (KR); Kim, Seok Won, 602-808 Busan (KR)
(74) Representative: Hengelhaupt, Jürgen

(56) References cited:
- EP-A2- 0 097 359
- EP-A2- 0 855 602
- GB-A- 1 033 915
- JP-A- 2003 057 437
- US-A1- 2002 050 783
- US-A1- 2005 186 421

## Description

### BACKGROUND OF THE INVENTION

### 1. Field of the Invention

The present invention relates to an optical member for a display apparatus and a filter for a display apparatus having the same, and more particularly, to an optical member for a display apparatus and a filter for a display apparatus having the same, which minimizes color rendering, thereby representing identical object colors regardless of types of external light sources.

### 2. Description of Related Art

In general, a plasma display panel (PDP) apparatus has a defect in that an amount of emitted electromagnetic (EM) radiation and near infrared (NI) radiation with respect to a driving characteristic is great, and thus EM radiation and NI radiation generated in the PDP apparatus may have harmful effects on human bodies, and cause sensitive equipment such as wireless telephones, remote controls, and the like, to malfunction. Therefore, in order to use the PDP apparatus, it is required to prevent emission of EM radiation and NI radiation emitted from the PDP apparatus from increasing to more than a predetermined level. A PDP filter is constructed such that functional films having functions such as an EM radiation-shielding function, an NI radiation-shielding function, and the like are stacked one upon another, and the stacked films are equipped in a front surface of the PDP apparatus.

In the case of a PDP filter of a mesh type, an anti-reflection/color correction film for preventing light reflection and improving color purity of an image is disposed in a viewer side, and a mesh film having an electromagnetic shielding function and a polyethylene terephthalate (PET) film for protecting the mesh film are disposed in a PDP module side. A heat strengthened glass acting as a supporter is interposed between the anti-reflection/color correction film and the mesh film.

In the case of a PDP filter of a conductive layer type, a coating layer with multi-conductive layers having an electromagnetic shielding function is stacked on a surface of the heat strengthened glass, and an anti-reflection/color correction film for preventing light reflection, improving color purity of an image, and protecting the coating layer is disposed on the coating layer.

The PDP filter is joined with the PDP module to thereby form the PDP apparatus. The PDP filter acts as an important element for determining appearances of PDP products. In particular, the appearance quality may be visibly conspicuous in a state of power OFF. Object colors of all objects vary minutely depending on an external light source. For example, complains by consumers may occur due to color differences between colors of the PDP products displayed in a shop and colors of the PDP products after being installed in the living room of the consumers.

As described above, a property in that object colors vary depending on the external light source is referred to as color rendering or metamerism. The document JP 2003 057437 A discloses an optical member according to the preamble of claim 1.

### SUMMARY OF THE INVENTION

An aspect of the present invention provides an optical member for a display apparatus which can reduce color rendering of a filter for a display apparatus.

Another aspect of the present invention provides a filter for a display apparatus having the optical member which can represent identical object colors regardless of types of external light sources.

According to an aspect of the present invention, there is provided an optical member for a display apparatus which includes a plurality of colorants. Also, the optical member includes a neon-cut colorant in which the full-width-half-maximum (FWHM) of the peak wavelength is about 35 nm or less, wherein a transmittance ratio (B/R) of blue light (B) with a wavelength of about 400 to 500 nm with respect to red light (R) with a wavelength of about 600 to 700 nm is about 0.84 or less.

In this instance, the peak wavelength may be about 580 to 600 nm. Preferably, the neon-cut colorant may be an azaporphyrin-based colorant.

According to another aspect of the present invention, there is provided a filter for a display apparatus. The filter includes an electromagnetic wave shielding member of either a mesh type or a conductive layer type; and an optical member i) performing an anti-reflection function and a color correction function, and ii) including a neon-cut colorant in which the full-width-half-maximum (FWHM) of the peak wavelength is about 35 nm or less, wherein a transmittance ratio (B/R) of blue light (B) with a wavelength of about 400 to 500 nm with respect to red light (R) with a wavelength of about 600 to 700 nm is about 0.84 or less.

In this instance, a color difference ΔE of the filter under standard illuminant A and under standard illuminant D65 is about 3.65 or less, thereby representing almost identical object colors regardless of types of external light sources.

### BRIEF DESCRIPTION OF THE DRAWINGS

The above and other aspects of the present invention will become apparent and more readily appreciated from the following detailed description of certain exemplary embodiments of the invention, taken in conjunction with the accompanying drawings of which:

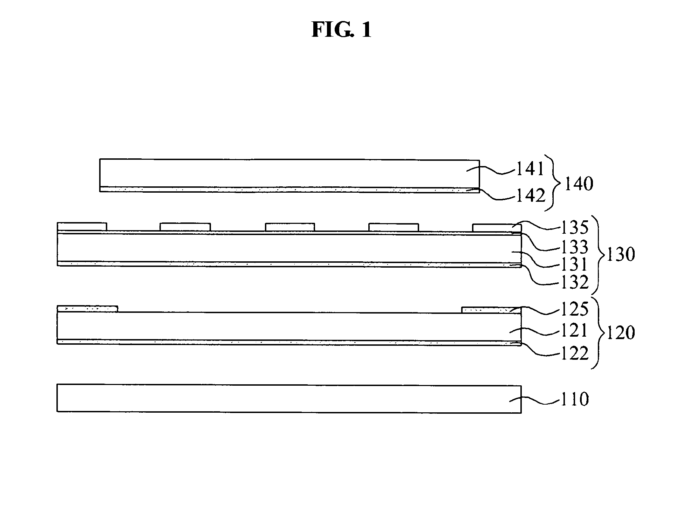

FIG. 1 is an exploded cross-sectional view illustrating a filter for a display apparatus according to an exemplary embodiment of the present invention; and

### DETAILED DESCRIPTION OF EXEMPLARY EMBODIMENTS

Reference will now be made in detail to exemplary embodiments of the present invention, examples of which are illustrated in the accompanying drawings, wherein like reference numerals refer to the like elements throughout. The exemplary embodiments are described below in order to explain the present invention by referring to the figures.

FIG. 1 is an exploded cross-sectional view illustrating a filter for a display apparatus according to an exemplary embodiment of the present invention. As shown in FIG. 1, the joining relation between respective films is illustrated in detail.

Referring to FIG. 1, the filter for the display apparatus according to the present exemplary embodiment includes an anti-reflection/color correction film 110, a transparent substrate 120, a mesh film 130, and a protection film 140.

The anti-reflection/color correction film 110 acting as an optical member for a display apparatus is disposed in a viewer side to prevent light reflection, thereby preventing deterioration of display quality due to the light reflection. Also, the anti-reflection/color correction film 110 performs color correction of a displayed image, and includes a plurality of colorants.

Specifically, the anti-reflection/color correction film 110 includes a neon-cut colorant for selectively absorbing a wavelength range of about 580 to 600 nm, and colorants of red type and blue type in order to achieve a balance of red (R), green (G), and blue (B) colors. The colorants of red type and blue type included in the anti-reflection/color correction film 110 have a predetermined combination ratio.

In the anti-reflection/color correction film 110 according to the combination ratio of the colorants, object colors may be visible differently depending on types of external light sources. In general, display apparatuses are mostly disposed under sunlight or interior lighting environments, and the interior lighting environment may be divided into a fluorescent lamp environment, an incandescent lamp environment, and the like.

Accordingly, a color difference ΔE of the anti-reflection/color correction film 110 is relatively great depending on each characteristic of standard illuminant A and standard illuminant D65 of International Commission on Illumination (CIE). The standard illuminant A being similar to an incandescent lamp is an illuminant largely emitting a red color which is acquired by replicating a light emitted from a surface temperature of a solar blackbody of about 2856K. The standard illuminant D65 is acquired by replicating a light emitted from a surface temperature of the solar blackbody of about 6500K. In this instance, the standard illuminant A and the standard illuminant D65 have illuminant spectrums different from each other.

When the color difference ΔE of the anti-reflection/color correction film 110 depending on the external light sources is relatively great, color rendering exceedingly increases. As a result, when the filter for the display apparatus is applicable to the display apparatus, appearance quality of the display apparatus is remarkably deteriorated.

Thus, in the anti-reflection/color correction film 110 according to the present exemplary embodiment of the invention, types and combinations of colorants included in the anti-reflection/color correction film 110 are specifically designed.

For this purpose, the neon-cut colorant according to the present exemplary embodiment preferably has a peak wavelength of about 580 to 600 nm. In particular, a colorant in which the full-width-half-maximum (FWHM) of the peak wavelength is relatively narrowed such as an azaporphyrin-based colorant may be used as the neon-cut colorant.

The FWHM of the peak wavelength of the neon-cut colorant is about 35 nm or less, and preferably about 31 nm or less.

Also, the colorants included in the anti-reflection/color correction film 110 are combined in a predetermined combination ratio in such a manner that a transmittance ratio (B/R) of blue light (B) with a wavelength of about 400 to 500 nm with respect to red light (R) with a wavelength of about 600 to 700 nm is about 0.84 or less.

Specifically, in order to minimize change in the object color depending on change in the external light source by reducing color rendering of the anti-reflection/color correction film 110, a transmittance of blue light (B) is required to be less than that of red light (R). For this purpose, appropriate types and combinations of colorants have to be considered at design time of the colorants. As described above, the colorant in which the FWHM of the peak wavelength is relatively narrowed such as the azaporphyrin-based colorant may be used as the neon-cut colorant. However, as specific examples for colorants performing a color correction function of blue type, red type, and black type, a diimmonium-based colorant, a nickel dithiol-based colorant, a phthalocyanine-based colorant, a cyanine-based colorant, an azo-based colorant, a quinophthalone-based colorant, an indigo-based colorant, and the like may be listed. Also, the present invention is not limited to theses colorants, various types of colorants other than these colorants may be used, which satisfy that the transmittance ratio (B/R) of blue light (B) with a wavelength of about 400 to 500 nm with respect to red light (R) with a wavelength of about 600 to 700 nm is about 0.84 or less. According to the present exemplary embodiment, to provide a design of colorants for reduction in the color rendering is included in the sprit of the invention.

Referring again to FIG. 1, the transparent substrate 120 includes a transparent member 121, a first adhesive layer 122, and a black ceramic 125. A glass and the like may be used for the transparent member 121. Specifically, a heat strengthened glass is preferably used for the transparent member 121. The first adhesive layer 122 is formed on the bottom surface of the transparent member 121, and adhered to the anti-reflection/color correction film 110, and thereby the first transparent 121 and the anti-reflection/color correction film 110 are joined together.

The black ceramic 125 is formed on an edge portion of the transparent member 121, and is a portion where an image is not displayed by blocking light emitted from a display panel (not shown). The transparent substrate 120 has a stepped structure including the black ceramic 125 formed thereon. In this instance, the black ceramic 125 is coated with a black ink.

The mesh film 130 includes a first base film 131, a second adhesive layer 132, a glue layer 133, and a metal thin film pattern 135. A polyethylene terephthalate (PET) resin and the like may be used for the first base film 131. The second adhesive layer 132 is formed on the bottom surface of the first base film 131, and combined with the transparent substrate 120 in such a manner that the mesh film 130 covers on the black ceramic 125 of the transparent substrate 120. Specifically, the transparent substrate 120 and the mesh film 130 are combined together by the second adhesive layer 132. The metal thin film pattern 135 is formed on the first base film 131. The metal thin film pattern 135 functions to block an electromagnetic wave and the like generated from the display panel of the display apparatus.

The metal thin film pattern 135 is adhered to the first base film 131 by the glue layer 133 made of a glue agent.

So that the metal thin film pattern 135 is formed on the first base film 131, a metal thin film made of copper and the like is first required to be adhered to the first base film 131. In order to improve the adhesive performance of the metal thin film, the outer surface of the first base film 131 is generally processed to be rough to thereby increase a surface area of the first base film 131. A glue agent is coated on the first base film 131 with the increased surface area to thereby form the glue layer 133, and the metal thin film pattern 135 is formed on the glue layer 133. The electromagnetic wave shielding function is substantially implemented by the metal thin film pattern 135.

The metal thin film pattern 135 is formed by patterning the metal thin film adhered on the glue layer 133 through an etching process and the like.

The protection film 140 is adhered to the mesh film 130. The protection film 140 includes a second base film 141 and a third adhesive layer 142. A third adhesive layer 142 is formed on the bottom surface of the protection film 140. The protection film 140 and the mesh film 130 are combined together by the third adhesive layer 142.

The second base film 141 is made from the same material as the first base film 131, however the present exemplary embodiment is not limited thereto.

A size of the protection film 140 is slightly smaller than that of the mesh film 130. Thus, some edge portions of the metal thin film pattern 135 are exposed to the outside, and the exposed metal thin film pattern 135 may be electrically grounded.

In the present exemplary embodiment, the filter for the display apparatus of the mesh type has been hitherto described as the filter for the display apparatus. However, the anti-reflection/color correction film 110 acting as the optical member for the display apparatus according to the present exemplary embodiment may be adapted to the filter for the display apparatus of the conductive layer type as well as the filter for the display apparatus of the mesh type, and thereby perform the same function.

The filter for the display apparatus where the anti-reflection/color correction film 110 is applied represents identical object colors regardless of types of external light sources, thereby improving the appearance quality of the display apparatus where the filter for the apparatus is adapted.

Specifically, a color difference ΔE of the filter for the display apparatus according to the present exemplary embodiment is about 3.65 or less under standard illuminant A and standard illuminant D65, and thus the color rendering may be significantly reduced.

Hereinafter, the anti-reflection/color correction film 110 acting as the optical member according to present exemplary embodiment will be described with specific examples, and further color rendering of the display apparatus where the anti-reflection/color correction film 110 is adapted will be described in detail.

### [Examples]

### [Example 1 and Example 2]

An anti-reflection/color correction film according to Examples 1 and 2 was manufactured, respectively, with colorant compositions as shown in Table 1 below. In this instance, the colorant compositions may be hereinafter expressed by weight percentage with respect to the polymer resin within the anti-reflection/color correction film. A product (product name: TAP2) manufactured by Yamamoto Chemical CO., Ltd. of Japan was used as the azaporphyrin-based colorant, and products (product name: ORASOL Blue, ORASOL Red, and ORASOL Black) manufactured by Ciba Specialty Chemical Inc. of Japan were used as the colorants of blue type, red type, and black type. Also, Poly Methyl Meta Acrylate (PMMA) was used as the transparent substrate formed on the anti-reflection/color correction film.

**[Table 1]**

| Classification | azaporphyrin-based colorant | Colorant of blue type | Colorant of red type | Colorant of black type |
|---|---|---|---|---|
| Example 1 | 0.14% | 0.0% | 0.07% | 0.2% |
| Example 2 | 0.12% | 0.1% | 0.10% | 0.1% |

### [Comparative Example]

An Anti-reflection/color correction film according to Comparative Example was manufactured with colorants compositions as shown in Table 2 below.

**[Table 2]**

| classification | cyanine-based colorant | Colorant of blue type | Colorant of red type | Colorant of black type |
|---|---|---|---|---|
| Comparative Example | 0.10% | 0.1% | 0.3% | 0.15% |

### <Transmittance analysis depending on wavelengths >

In the case of the anti-reflection/color correction film of Examples 1 and 2, the FWHM of a neon light absorption peak at a spectral range of about 580 to 600 nm (*neon light absorption peak of about 580 to 600 nm) was relatively narrowed, and a transmittance ratio (B/R) of blue light (B) with a wavelength of about 400 to 500 nm with respect to red light (R) of about with a wavelength 600 to 700 nm was relatively great in comparison with the anti-reflection/color correction film of Comparative Example.

### [Manufacture Examples 1 and 2]

Each filter for a display apparatus according to Manufacture Examples 1 and 2 was manufactured, in which the respective anti-reflection/color correction films of Examples 1 and 2 were applied. The filter for the display apparatus had the same structure as in FIG. 1.

### [Comparative Manufacture Example]

A filter for a display apparatus according to Comparative Manufacture Example was manufactured in the same manner in Manufacture Examples 1 and 2, except that the anti-reflection/color correction film of Comparative Example was applied.

### Measurement results for object color

Each object color of the filters for the display apparatus of Manufacture Examples 1 and 2, and Comparative Manufacture Example was observed under standard illuminant A and standard illuminant D65 using a spectrophotometer (Lambda 950) manufactured by Perkin-Elmer, Inc. Color coordinates of L* , a* , b* specified by CIE under standard illuminant A and standard illuminant D65, and a color difference ΔE of the anti-reflection/color correction film under standard illuminant A and standard illuminant D65 were measured, respectively, and the measurement results are shown in Table 3 below.

**[Table 3]**

| classification | Standard illuminant A | | | Standard illuminant D65 | | | ΔE |
|---|---|---|---|---|---|---|---|
| | L* | a* | b* | L* | a* | b* | |
| Manufacture Example 1 | 72.4 | 1.16 | -7.98 | 73.07 | -0.07 | -6.41 | 3.65 |
| Manufacture Example 2 | 82.58 | 4.08 | 6.26 | 82.01 | 2.71 | 4.97 | 1.96 |
| Comparative Manufacture Example | 76.1 | 4.55 | -10.07 | 76.75 | -0.1 | -7.92 | 5.16 |

As can be seen in Table 3, it was found that L* gets brighter along with an increase as a positive value, and gets darker along with an increase as a negative value. It was found that a* becomes red along with an increase as the positive value, and becomes green along with an increase as the negative value. Also, it was found that b* becomes yellow along with an increase as the positive value, and becomes blue along with an increase as the negative value. An achromatic color could be viewed as values of a* and b* approach '0'.

As can be seen in Table 3, in the case of the filter for the display apparatus manufactured in Manufacture Examples 1 and 2, the ΔE was 3.65 and 1.96, respectively, which are relatively small. Conversely, in the case of the filter for the display apparatus manufactured in Comparative Manufacture Example, the ΔE was 5.16, which is relatively large. Accordingly, it was found that the filter for the display apparatus of Manufacture Examples 1 and 2 has less color rendering due to the ΔE having a relatively smaller value.

### FWHM and transmittance analysis for blue light/red light

Each FWHM of the anti-reflection/color correction film of Examples 1 and 2, and Comparative Example, which was applied to the filter for the display apparatus manufactured in Manufacture Examples 1 and 2, and Comparative Manufacture Example, and a transmittance ratio of blue light to red light were analyzed, and the analysis results are shown in Table 4 below.

**[Table 4]**

| | FWHM (λ max. 590~593 nm) | Blue light (480 nm) transmittance/ Red light (630 nm) transmittance | ΔE |
|---|---|---|---|
| Example 1 | 17 nm | 0.84 | 3.65 |
| Example 2 | 31 nm | 0.66 | 1.96 |
| Comparative Example | 46 nm | 0.94 | 5.16 |

In the case of Examples 1 and 2, it was found that only a wavelength of a specific range was selectively absorbed due to the FWHM of the peak wavelength of 35 nm or less, which was relatively small. As absorption wavelength range becomes smaller and the B/R transmittance ratio becomes 0.84 or less, change in colors depending on change in light sources becomes less, thereby improving the color rendering.

As described above, according to the present invention, the optical member for the display apparatus is applied to the filter for the display apparatus by newly designing colorants, thereby reducing the color rendering of the filter for the display apparatus.

According to the present invention, the display apparatus where the filter for the display apparatus is adapted represents identical object colors regardless of types of external light sources, thereby maintaining superior appearance quality of the display apparatus.

Although a few exemplary embodiments of the present invention have been shown and described, the present invention is not limited to the described exemplary embodiments.

## Claims

1. An optical member for a display apparatus which includes a plurality of colorants, the optical member comprising:
a neon-cut colorant in which the full-width-half-maximum (FWHM) of the peak wavelength is 35 nm or less, **characterized in that**
a transmittance ratio (B/R) of blue light (B) with a wavelength of 400 to 500 nm with respect to red light (R) with a wavelength of 600 to 700 nm is 0.84 or less.

2. The optical member of claim 1, wherein the peak wavelength is 580 to 600 nm.

3. The optical member of claim 1, wherein the neon-cut colorant is an azaporphyrin-based colorant.

4. A filter for a display apparatus, the filter comprising:
an electromagnetic wave shielding member of either a mesh type or a conductive layer type; and
the optical member of claim 1 performing an anti-reflection function and a color correction function.

5. The filter of claim 4, wherein a color difference △E of the filter under standard illuminant A and under standard illuminant D65 is 3.65 or less.

6. The filter of claim 4, wherein the optical member is a film including a polymer resin.

## Patentansprüche

1. Optisches Bauteil für eine Anzeigevorrichtung, welches mehrere Farbstoffe enthält, wobei das optische Bauteil aufweist:
einen Neon-Cut-Farbstoff, in dem die Halbwertsbreite (FWHM) der Peak-Wellenlänge 35 nm oder kleiner ist, **dadurch gekennzeichnet, dass**
ein Transmissionsgrad-Verhältnis (B/R) des blauen Lichts (B) mit einer Wellenlänge von 400 bis 500 nm bezüglich des roten Lichts (R) mit einer Wellenlänge von 600 bis 700 nm gleich 0,84 oder kleiner ist.

2. Optisches Bauteil nach Anspruch 1, wobei die Peak-Wellenlänge 580 bis 600 nm ist.

3. Optisches Bauteil nach Anspruch 1, wobei der Neon-Cut-Farbstoff ein Farbstoff auf Azaporphyrin-Basis ist.

4. Filter für eine Anzeigevorrichtung, wobei das Filter aufweist:
ein Abschirmbauteil für elektromagnetische Wellen entweder vom Gittertyp oder vom Typ einer leitfähigen Schicht; und
das optische Bauelement nach Anspruch 1, das eine Antireflexionsfunktion und eine Farbkorrekturfunktion ausführt.

5. Filter nach Anspruch 4, wobei eine Farbdifferenz ΔE des Filters unter der Standardlichtquelle A und unter der Standardlichtquelle D65 gleich 3,65 oder kleiner ist.

6. Filter nach Anspruch 4, wobei das optische Bauelement ein Film ist, der ein Polymerharz enthält.

## Revendications

1. Élément optique pour un appareil d'affichage qui inclut une pluralité de colorants, l'élément optique comprenant :
un colorant de type néon où la largeur à mi-hauteur (FWHM) de la longueur d'onde du pic est de 35 nm ou
moins, **caractérisé par**
un pourcentage de transmission (B/R) de la lumière bleue (B), avec une longueur d'onde de 400 à 500 nm,
par rapport à la lumière rouge (R), avec une longueur d'onde de 600 à 700 nm, qui est de 0,84 ou moins.

2. Élément optique de la revendication 1, où la longueur d'onde du pic fait 580 à 600 nm.

3. Élément optique de la revendication 1, où le colorant de type néon est un colorant à base d'azaporphyrine.

4. Filtre pour appareil d'affichage, le filtre comprenant:
un pare-onde électromagnétique de type maillé ou couche conductrice; et
l'élément optique de la revendication 1 ayant une fonction anti-réflexion et une fonction de correction de couleur.

5. Filtre de la revendication 4, où une différence de couleur ΔE du filtre sous illuminant standard A et sous illuminant standard D65 est de 3,65 ou moins.

6. Filtre de la revendication 4, où l'élément optique est un filtre incluant une résine polymère.
